# EUROPÄISCHE PATENTSCHRIFT

(11) **EP 1 697 998 B1**
(45) Veröffentlichungstag und Bekanntmachung des Hinweises auf die Patenterteilung: **30.06.2010**
(21) Anmeldenummer: 04820848.2
(22) Anmeldetag: 26.11.2004
(51) Int. Cl.: H01L 29/786

(54) **FELDEFFEKTTRANSISTOR MIT HETEROSCHICHTSTRUKTUR SOWIE ZUGEHÖRIGES HERSTELLUNGSVERFAHREN**
FIELD EFFECT TRANSISTOR WITH A HETEROSTRUCTURE AND ASSOCIATED PRODUCTION METHOD
TRANSISTOR A EFFET DE CHAMP DOTE D'UNE STRUCTURE A COUCHES HETEROGENES ET PROCEDE DE FABRICATION ASSOCIE

(30) Priorität: 23.12.2003 DE 10360874
(43) Veröffentlichungstag der Anmeldung: 06.09.2006
(73) Patentinhaber: Infineon Technologies AG, 85579 Neubiberg (DE)
(72) Erfinder: SCHRÜFER, Klaus, 85598 Baldham (DE)
(74) Vertreter: Kindermann, Peter
(86) Internationale Anmeldenummer: PCT/EP2004/053132
(87) Internationale Veröffentlichungsnummer: WO 2005/064686

(56) Entgegenhaltungen:
- US-A- 6 059 895
- US-A1- 2003 162 335
- DATABASE INSPEC [Online] THE INSTITUTION OF ELECTRICAL ENGINEERS, STEVENAGE, GB; 15. März 2004 (2004-03-15), LOO R ET AL: "Fabrication of 50 nm high performance strained-SiGe pMOSFETs with selective epitaxial growth" XP002317024 Database accession no. 8004464 -& FIRST INTERNATIONAL SIGE TECHNOLOGY AND DEVICE MEETING (ISTDM 2003) FROM MATERIALS AND PROCESS TECHNOLOGY TO DEVICE AND CIRCUIT TECHNOLOGY 15-17 JAN. 2003 NAGOYA, JAPAN, Bd. 224, Nr. 1-4, 15. März 2004 (2004-03-15), Seiten 292-296, XP002317023 Applied Surface Science Elsevier Netherlands ISSN: 0169-4332
- YEE-CHIA YEO ET AL: "Enhanced performance in sub-100 nm CMOSFETs using strained epitaxial silicon-germanium" 10. Dezember 2000 (2000-12-10), , PAGE(S) 753-756 , XP010531871 das ganze Dokument
- TAKAGI T ET AL: "A NOVEL HIGH PERFORMANCE SIGE CHANNEL HETEROSTRUCTURE DYNAMIC THRESHOLD PMOSFET (HDTMOS)" IEEE ELECTRON DEVICE LETTERS, IEEE INC. NEW YORK, US, Bd. 22, Nr. 5, Mai 2001 (2001-05), Seiten 206-208, XP001086934 ISSN: 0741-3106
- SHIMA M ET AL: "CHANNEL STRAINED-SIGE P-MOSFET WITH ENHANCED HOLE MOBILITY AND LOWER PARASITIC RESISTANCE" 2002 SYMPOSIUM ON VLSI TECHNOLOGY. DIGEST OF TECHNICAL PAPERS. HONOLULU, JUNE 11 - 13, 2002, SYMPOSIUM ON VLSI TECHNOLOGY, NEW YORK, NY : IEEE, US, 11. Juni 2002 (2002-06-11), Seiten 94-95, XP001109834 ISBN: 0-7803-7312-X
- BEAN J C: "SILICON-BASED SEMICONDUCTOR HETEROSTRUCTURES: COLUMN IV BANDGAP ENGINEERING" 1. April 1992 (1992-04-01), PROCEEDINGS OF THE IEEE, IEEE. NEW YORK, US, PAGE(S) 571-587 , XP000304349 ISSN: 0018-9219 in der Anmeldung erwähnt das ganze Dokument

## Beschreibung

Die vorliegende Erfindung bezieht sich auf einen Feldeffekttransistor mit Heteroschichtstruktur sowie ein zugehöriges Herstellungsverfahren und insbesondere auf einen Sub-100 nm-Feldeffekttransistor mit vollständig verarmtem (fully depleted) aktiven Gebiet.

Mit der fortschreitenden Entwicklung von Halbleiterbauelementen und insbesondere von Feldeffekttransistoren werden zur Verbesserung einer Integrationsdichte und Schaltgeschwindigkeit immer kleiner werdende Strukturgrößen angestrebt. Hierbei stößt man jedoch aufgrund einer begrenzten Ladungsträgerbeweglichkeit in Halbleitermaterialien an bestimmte Grenzen. Da eine obere Grenze der Ladungsträgerbeweglichkeit von Elektronen und Löchern in einem Halbleiterkristall von den physikalischen Eigenschaften des Halbleiterkristalls abhängt, wird die Schaltgeschwindigkeit der Feldeffekttransistoren inherent vom Halbleiterkristall begrenzt. Darüber hinaus verursachen auch für die steigende Integrationsdichte notwendige sogenannte high-k-Gatedielektrika (d.h. Dielektrika mit hoher Dielektrizitätskonstante) eine verringerte Ladungsträgerbeweglichkeit.

Es wurden daher sogenannte Feldeffekttransistoren mit stressaufnehmenden bzw. verspannten Halbleiterschichten (strained semiconductor) entwickelt, wodurch eine Ladungsträgerbeweglichkeit in einem verspannten Halbleiterkristall verbessert werden kann.

Bei modernen Logik-Chips, wie beispielsweise Mikro-Controllern, Mikro-Prozessoren, Telekommunikations-Chips usw., besteht ferner eine wesentliche Forderung darin, die Einsatzspannung (bzw. Schwellwertspannung Vt) der Feldeffekttransistoren (n/p-MOS) auf eine jeweilige Applikation angepasst, hochgenau einstellen zu können. Bei herkömmlichen beispielsweise CMOS-Feldeffekttransistoren mit ihren n⁺/p⁺-polykristallinen Gate-Elektroden wird diese Einsatzspannung üblicherweise über die Substratdotierung eingestellt. Bei den nachfolgend diskutierten vollständig verarmten Halbleiterstrukturen bzw. "fully depleted silicon on insulator"-Strukturen kann diese Einsatzspannung der Feldeffekttransistoren jedoch nicht mehr wie üblich über eine Substratdotierung eingestellt werden, da die statistische Variation der Dotierstoffe in dem kleinen aktiven Volumen zu extrem starken, für Schaltungs-Designer nicht akzeptablen Fluktuationen in der Einsatzspannung führen würde. Ferner kann n/p-dotiertes Polysilizium als Gate-Elektrode auch nicht mehr verwendet werden, da diese Materialien zu extrem niedrigen Einsatzspannungen führen und somit für zukünftige Logik-Bausteine ungeeignet sind.

Eine Methode zur Beseitigung dieser Probleme ist über die Variation der Gate-Kapazität die Einsatzspannung eines Feldeffekttransistors einzustellen. Hierbei wird der Umstand ausgenutzt, dass mit abnehmender Gate-Kapazität die Einsatzspannung des Feldeffekttransistors zunimmt.

Eine weitere Methode zur Einstellung einer Einsatzspannung von Feldeffekttransistoren bestand herkömmlicherweise darin, die sogenannte Flachbandspannung, die im Wesentlichen von der Differenz der Austrittsarbeiten der Gate-Elektrode und dem Substratmaterial abhängt, in geeigneter Weise zu verändern. Für eine undotierte FD-SOI-Struktur (fully depleted silicon on insulator) führt beispielsweise eine Gate-Elektrode aus Metall mit einer Austrittsarbeit von 4,7 eV zu symmetrischen Einsatzspannungen für den n- und p-MOS-Feldeffekttransistoren. Dieser Ansatz führt jedoch zu sehr hohen Einsatzspannungen von etwa 500 mV für n- und p-MOS-Feldeffekttransistoren und ist daher nicht geeignet für zukünftige Logik-Bausteine. Insbesondere sogenannte ASICs (application specific integrated circuit) oder Mikro-Prozessoren, für die eine Einsatzspannung der Feldeffekttransistoren von maximal 350 mV notwendig sind, können derartige herkömmliche Verfahren bzw. Feldeffekttransistoren nicht verwendet werden.

Grundsätzlich könnte weiterhin versucht werden, die Austrittsarbeit der Gate-Elektroden beispielsweise mittels Implantation geeigneter Dotierstoffe oder durch Verwendung verschiedener Metalle oder Metall-Legierungen derart zu verändern, dass sich eine geeignete bzw. ausreichend kleine Einsatzspannung ergibt. Dabei ergeben sich jedoch außerordentlich hohe Schwierigkeiten, überhaupt die exakt richtigen Materialien zu finden und diese in einem CMOS-Prozess zu integrieren. Insbesondere die Anforderungen an eine symmetrische Einsatzspannung in einer CMOS-Schaltung für sowohl n-als auch p-MOS-Feldeffekttransistoren führt zu außerordentlich kostenintensiven Lösungen.

Yee-Chia Yeo et al, "Enhanced Performance in Sub-100 nm CMOSFETs using Strained Epitaxial Silicon-Germanium", International Electron Devices Meeting Technical Digest 2000, 10-13 Dezember 2000, veröffentlicht ein CMOS Struktur mit gespannten Halbleiterschichten in einem CMOS Prozess.

Der Erfindung liegt daher die Aufgabe zugrunde, einen Feldeffekttransistor mit Heteroschichtstruktur sowie ein zugehöriges Herstellungsverfahren zu schaffen, wobei auf einfache und kostengünstige Art und Weise eine Einsatzspannung des Feldeffekttransistors hochgenau eingestellt werden kann.

Erfindungsgemäß wird diese Aufgabe hinsichtlich des Feldeffekttransistors durch die Merkmale der Patentansprüche 1 und 3 sowie hinsichtlich des Verfahrens durch die Maßnahmen des Patentanspruchs 13 gelöst.

Gemäß einer ersten Alternative weist ein Feldeffekttransistor demzufolge ein Trägermaterial auf, das als oberste Schicht eine entspannte monokristalline Halbleiterschicht aus einem ersten Halbleitermaterial besitzt. Auf der entspannten Halbleiterschicht ist eine verspannte monokristalline Halbleiterschicht ausgebildet, die eine Halbleiterlegierung aus dem ersten Halbleitermaterial und zumindest einem zweiten Halbleitermaterial besitzt, wobei ein Anteil des zweiten Halbleitermaterials frei einstellbar ist. Auf der verspannten Halb-leiterschicht befindet sich eine Gate-Isolationsschicht und eine Gate-Schicht, wobei zum Festlegen eines undotierten Kanalgebiets seitlich von der Gate-Schicht Drain-/Source-Gebiete zumindest in der verspannten Halbleiterschicht ausgebildet sind. Durch die Veränderung des Anteils des zweiten Halbleitermaterials innerhalb der aus einer Halbleiterlegierung bestehenden verspannten monokristallinen Halbleiterschicht kann nunmehr sehr genau eine Einsatzspannung des Feldeffekttransistors eingestellt werden. Die vorteilhaften Eigenschaften einer hohen Ladungsträgerbeweglichkeit aufgrund des verspannten Halbleitermaterials werden dabei weiterhin ausgenutzt.

Gemäß einer zweiten Alternative kann zwischen die oberste Schicht des Trägermaterials und die verspannte monokristalline Halbleiterschicht, welche aus einer Halbleiterlegierung mit frei einstellbarem Anteil des zweiten Halbleitermaterials besteht, ferner eine weitere entspannte monokristalline Halbleiterschicht eingefügt werden, die auf der ersten entspannten Halbleiterschicht ausgebildet ist und eine weitere Halbleiterlegierung aus dem ersten Halbleitermaterial und zumindest einem zweiten Halbleitermaterial aufweist, wobei ein weiterer Anteil des zweiten Halbleitermaterials innerhalb der weiteren Halbleiterlegierung wiederum frei einstellbar ist. An der Oberfläche dieser weiteren entspannten Halbleiterschicht ist ferner eine weitere verspannte monokristalline Halbleiterschicht ausgebildet, die wiederum aus dem ersten Halbleitermaterial besteht. Auf diese Weise können die aufgrund von unsymmetrischen Bandkantendiskontinuitäten entstehenden Unsymmetrien für p- und n-Feldeffekttransistoren kompensiert werden, wodurch man für ein gleiches Gate-Elektrodenmaterial und für gleiche Substratmaterialien symmetrische Einsatzspannungen sowohl für n- als auch für p-Feldeffekttransistoren erhält. Hochwertige CMOS-Schaltungen können dadurch besonders einfach hergestellt werden.

vorzugsweise ist die Summe der Dicken der entspannten und verspannten Halbleiterschichten kleiner ein Drittel einer Länge des Kanalgebiets, wodurch man zuverlässig sogenannte vollständig verarmte bzw. "fully depleted" Halbleiterstrukturen erhält.

Die Gate-Schicht weist vorzugsweise ein metallisches Material mit einer Austrittsarbeit von 4,5 eV bis 4,9 eV und vorzugsweise von 4,7 eV auf, welches auch als sogenanntes "mid gap"-Metall bezeichnet wird.

Als erstes Halbleitermaterial wird vorzugsweise Silizium und als zweites Halbleitermaterial Germanium verwendet, wodurch unter Verwendung von leicht beherrschbaren Materialien die notwendigen Halbleiterlegierungen hinsichtlich ihrer Anteile ausreichend genau eingestellt werden können.

Als Trägermaterial wird beispielsweise ein SOI-Substrat (silicon on insulator) verwendet, wobei auch ein Siliziumsubstrat mit vergrabener SiO₂-Schicht als "buried oxide" verwendet werden kann.

Zur Realisierung einer geeigneten Gate-Kapazität werden weiterhin SiO₂ oder ein sogenanntes high-k-Dielektrikum verwendet, wodurch sich entweder die Herstellung stark vereinfacht oder die Gate-Kapazität stark anheben lässt.

Vorzugsweise werden die Schichtdicken der verspannten Halbleiterschichten derart gewählt, dass ein stabiler Stress bzw. eine stabile Verspannung für Ge-Anteile x von bis zu 0,5 gewährleistet werden kann. Bei derartigen Schichtdicken können aus elektrostatischer Sicht (Kurzkanaleffekte) Kanallängen bis zu etwa 20 bis 30 nm realisiert werden.

Vorzugsweise wird der Feldeffekttransistor für eine CMOS-Schaltung eingesetzt, wobei sich unter Verwendung der gleichen Materialien für die Schichtstruktur des Feldeffekttransistors eine symmetrische Einsatzspannung für den n- sowie für den p-Feldeffekttransistor ergibt.

Hinsichtlich des Verfahrens zur Herstellung eines Feldeffekttransistors mit Heteroschichtstruktur wird vorzugsweise zunächst ein Trägermaterial vorbereitet, das als oberste Schicht eine entspannte monokristalline Halbleiterschicht aus einem ersten Halbleitermaterial aufweist. Anschließend wird an der Oberfläche der entspannten Halbleiterschicht eine verspannte monokristalline Halbleiterschicht ausgebildet, die eine Halbleiterlegierung aus dem ersten Halbleitermaterial und zumindest einem zweiten Halbleitermaterial aufweist, wobei ein Anteil des zweiten Halbleitermaterials frei einstellbar ist. An der Oberfläche der verspannten Halbleiterschicht wird anschließend eine Gate-Isolationsschicht und eine Gate-Schicht ausgebildet, wobei zum Festlegen eines undotierten Kanalgebiets schließlich seitlich von der Gate-Schicht Drain-Gebiete und Source-Gebiete zumindest in der verspannten Halbleiterschicht ausgebildet werden. Die Herstellung eines Feldeffekttransistors mit frei einstellbarer Einsatzspannung ist demzufolge sehr einfach und kostengünstig.

Wiederum kann zur Realisierung von symmetrischen Einsatzspannungen für n- und p-Feldeffekttransistoren bei Verwendung gleicher Materialien zusätzlich eine weitere entspannte monokristalline Halbleiterschicht, die aus einer weiteren frei einstellbaren Halbleiterlegierung besteht, und eine zusätzliche verspannte monokristalline Halbleiterschicht, die aus dem ersten Halbleitermaterial besteht, zwischen die oberste Schicht des Trägermaterials und die verspannte monokristalline Halbleiterschicht, welche aus der Halbleiterlegierung besteht, eingefügt werden, wobei auch ein Anteilsverhältnis der zusätzlich eingefügten Halbleiterlegierung zur Symmetrisierung der Einsatzspannungen frei einstellbar ist.

Zum Ausbilden der verspannten und entspannten Halbleiterschichten auf dem Trägermaterial wird vorzugsweise ein Epitaxieverfahren und insbesondere Molekularstrahlepitaxie verwendet, wodurch sich sehr kleine Schichtdicken äußerst genau und relativ einfach herstellen lassen.

In den Unteransprüchen sind weitere vorteilhafte Ausgestaltungen der Erfindung gekennzeichnet.

Die Erfindung wird nachstehend an Hand von Ausführungsbeispielen unter Bezugnahme auf die Zeichnung näher beschrieben.

Es zeigen:
- Figur 1: eine vereinfachte Schnittansicht eines Feldeffekt- transistors mit Heteroschichtstruktur gemäß einem ersten Ausführungsbeispiel;
- Figuren 2A und 2B: eine vereinfachte Darstellung des Bandkantenver- laufs des Feldeffekttransistors gemäß Figur 1 für den Fall einer Flachbandspannung und einer Inversi- on;
- Figur 3: eine vereinfachte Darstellung zur Veranschaulichung des Zusammenhangs von Bandlücke und Ge-Anteil für eine GeₓSi₁₋ₓ-Halbleiterlegierung;
- Figur 4: eine vereinfachte Darstellung zur Veranschaulichung der Herstellungsmöglichkeiten für verspannte und entspannte Halbleiterschichten;
- Figur 5: eine vereinfachte Darstellung eines Bandkantenver- laufs für eine verspannte GeₓSi₁₋ₓ-Halbleiterlegie- rung, die auf einer verspannten Si-Halbleiter- schicht ausgebildet ist;
- Figur 6: eine vereinfachte Schnittansicht eines Feldeffekt- transistors mit Heteroschichtstruktur gemäß einem zweiten Ausführungsbeispiel; und
- Figur 7: eine vereinfachte Darstellung eines Bandkantenver- laufs des Feldeffekttransistors gemäß Figur 6 für den Fall einer Flachbandspannung und einer Inversi- on.

Die Erfindung wird nachfolgend an Hand eines Feldeffekttransistors mit Heteroschichtstruktur beispielhaft beschrieben, wobei als erstes Halbleitermaterial Si, als zweites Halbleitermaterial Ge und als Halbleiterlegierung GeₓSi₁₋ₓ verwendet wird. Sie ist jedoch nicht darauf beschränkt und umfasst in gleicher Weise Feldeffekttransistoren mit alternativen Halbleitermaterialien.

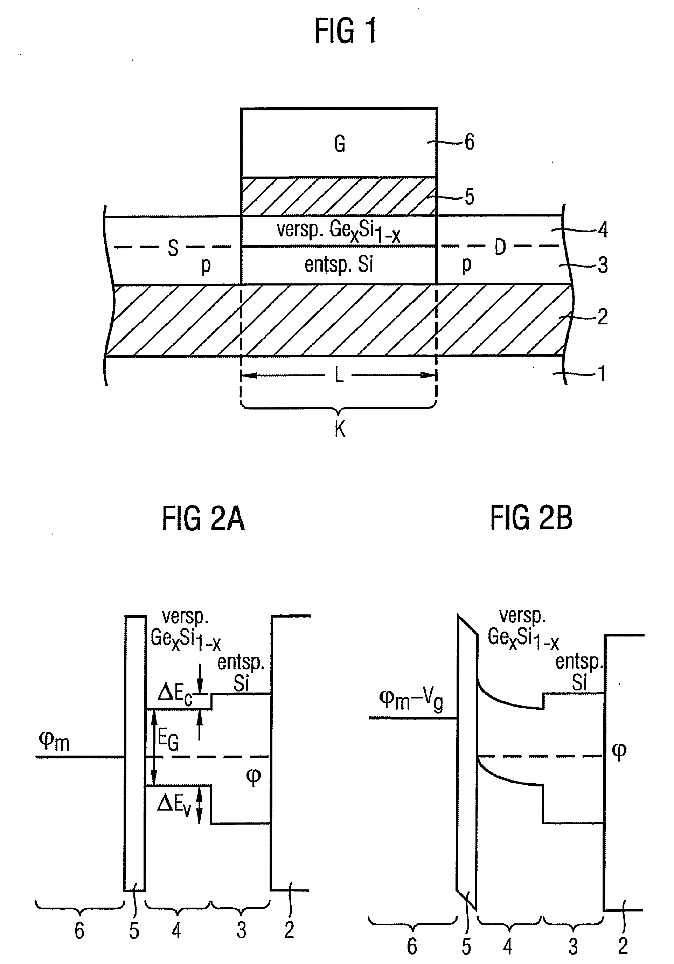

Figur 1 zeigt eine vereinfachte Schnittansicht zur Veranschaulichung eines Feldeffekttransistors mit Heteroschichtstruktur gemäß einem ersten Ausführungsbeispiel.

Als Trägermaterial für den erfindungsgemäßen Feldeffekttransistor wird beispielsweise ein sogenanntes SOI-Substrat (silicon on insulator) verwendet, welches ein Halbleitersubstrat 1, eine darauf ausgebildete dünne Isolationsschicht 2 und eine darauf ausgebildete Halbleiterschicht 3 aufweist. Das Halbleitersubstrat 1 besteht beispielsweise aus Silizium, wobei die Isolationsschicht 2 aus SiO₂ besteht und die oberste Schicht 3 eine entspannte monokristalline Halbleiterschicht aus Silizium aufweist.

Die nachfolgend noch mehrmals verwendeten Begriffe entspannte und verspannte bzw. "relaxed" und "strained" Halbleiterschicht beziehen sich hierbei auf monokristalline Halbleiterschichten, die aufgrund von äußeren Randbedingungen entspannt, also relaxiert, oder verspannt bzw. "strained" sind, wodurch sich ihre elektrische Eigenschaften verändern.

Alternativ zu dem SOI-Substrat kann als Trägermaterial auch ein herkömmlicher Halbleiterwafer verwendet werden, in dessen Oberflächenbereich eine vergrabene Isolierschicht als Isolierschicht 2 beispielsweise mittels Sauerstoffimplantation ausgebildet wird. Derartige vergrabene Isolierschichten werden auch als "buried oxide" bezeichnet.

Die entspannte Halbleiterschicht 3 besteht aus einem ersten Halbleitermaterial (z.B. Si) und weist eine Dicke von 3 bis 5 nm auf, wobei die Schichtdicke ferner beispielsweise durch epitaktisches Halbleiterwachstum auf eine gewünschte Schichtdicke eingestellt werden kann.

An der Oberfläche der entspannten Halbleiterschicht 3 wird nunmehr vorzugsweise mittels eines Abscheideverfahrens eine verspannte monokristalline Halbleiterschicht 4 ausgebildet, die eine Halbleiterlegierung aus dem ersten Halbleitermaterial der entspannten Halbleiterschicht 3, d.h. Silizium und zumindest einem zweiten Halbleitermaterial, wie beispielsweise Germanium, aufweist. Daraus ergibt sich eine sogenannte IV-IV-Halbleiterlegierung GeₓSi₁₋ₓ. Der Anteil x des zweiten Halbleitermaterials bzw. des Germaniums ist bei diesem Abscheidevorgang frei einstellbar, wobei die Genauigkeit der Einstellung durch die Prozessparameter sehr leicht festgelegt werden kann. Als Abscheideverfahren wird vorzugsweise ein epitaktisches Verfahren und insbesondere die sogenannte Molekularstrahlepitaxie verwendet.

Durch die freie Einstellbarkeit des Anteils x des Germaniums kann nunmehr die Einsatzspannung des Feldeffekttransistors in einem Bereich von 450 mV variiert und hochgenau eingestellt werden, wie nachfolgend im Einzelnen erläutert wird.

Zunächst seien jedoch noch weitere Herstellungsschritte zur Vervollständigung des Feldeffekttransistors kurz beschrieben. Nach dem Ausbilden der verspannten Halbleiterschicht 4, die ebenfalls eine Dicke von ca. 3 bis 5 nm aufweist, wird anschließend eine Gate-Isolationsschicht 5 ausgebildet, die beispielsweise SiO₂ oder ein sogenanntes "high-k-Dielektrikum" aufweist. Die Vorteile derartige Dielektrika mit besonders hoher Dielektrizitätskonstante liegen darin, dass eine für die Einsatzspannung wesentliche Gate-Kapazität dadurch erhöht werden kann. Grundsätzlich können auch andere Materialien und insbesondere Mehrschichtstrukturen wie beispielsweise ONO-Schichtfolgen (Oxid-Nitrid-Oxid) als Gate-Isolationsschicht 5 verwendet werden. Die Dicke dieser Schicht 5 liegt in einem Bereich von 1 bis 10 nm und weist vorzugsweise 1 bis 2 nm auf.

An der Oberfläche der Gate-Isolationsschicht 5 wird anschließend eine Gate-Schicht 6 ausgebildet, wobei vorzugsweise metallische Materialien und insbesondere sogenannte "mid gap"-Metalle mit einer Austrittsarbeit von 4,5 eV bis 4,9 eV verwendet werden. Insbesondere für die verwendeten Halbleitermaterialien Germanium und Silizium bietet sich ein "mid gap"-Metall mit einer Austrittsarbeit von 4,7 eV zur Realisierung von symmetrischen Einsatzspannungen für den n- und p-MOS-Feldeffekttransistor an. Für die Gate-Schicht 6 bzw. die Gate-Elektrode G sind demzufolge metallische Materialien wie beispielsweise NiSi, TiN, CoSi usw. möglich. Die Dicke dieser Gate-Schicht 6 beträgt beispielsweise 100 nm.

Nach dem Ausbilden dieser Gate-Isolationsschicht 5 und der Gate-Schicht 6 erfolgt nunmehr eine aus dem Stand der Technik bekannte Strukturierung zum Ausbilden eines strukturierten Gatestapels, wobei beispielsweise unter Verwendung fotolithografischer Verfahren und nachfolgender Ätztechnik der Gatestapel gemäß Figur 1 ausgebildet wird. Anschließend kann unter Verwendung von (nicht dargestellten) Spacern eine Ionenimplantation unter Verwendung des Gatestapels als Maske durchgeführt werden, wodurch Source-Gebiete S und Drain-Gebiete D zumindest in der verspannten Halbleiterschicht 4 aber auch in der entspannten Halbleiterschicht 3 ausgebildet werden.

Auf diese Weise erhält man einen Feldeffekttransistor mit einem undotierten Kanal K, der seitlich durch die Drain-/Source-Gebiete D und S festgelegt wird und hinsichtlich seiner Höhe durch die Isolationsschicht 2 und die Gate-Isolationsschicht 5 begrenzt ist. Zur Realisierung von sogenannten "fully depleted" bzw. vollständig verarmten Feldeffekttransistoren ist die Summe der Dicken der entspannten und verspannten Halbleiterschichten 3 und 4 kleiner ein Drittel einer Länge L des Kanalgebiets K.

Erfindungsgemäß kann somit die Einsatzspannung insbesondere von FD-SOI-Feldeffekttransistoren (fully depleted silicon on insulator) über eine Änderung der Halbleiteranteile einer Halbleiterlegierung in der verspannten Schicht 4 beliebig und hochgenau eingestellt werden. Im Einzelnen sei dies an Hand der Figuren 2 bis 4 näher erläutert.

Figuren 2A und 2B zeigen jeweils eine vereinfachte Darstellung zur Veranschaulichung eines schematischen Bandkantenverlaufs der in Figur 1 dargestellten Schichtstruktur bei einer Flachbandspannung, d.h. bei Anlegen einer Spannung, bei der das Valenz- und Leitungsband einen flachen Verlauf zeigen, und gemäß Figur 2B bei Inversion, d.h. Anlegen eine Spannung V_{g} an der Gate-Schicht 6, für einen p-MOS-Feldeffekttransistor. Mit f ist hierbei das Ferminiveau des Halbleiters angedeutet, während fₘ das Ferminiveau der metallischen Gate-Schicht 6 zeigt, die bei Metallen mit der Leitungsbandkante übereinstimmt. Mit E_{G} ist jeweils die Bandlücke bezeichnet, die im Wesentlichen eine Energie festlegt, die zum "Hochheben" eines Elektrons vom Valenzband in das Leitungsband benötigt wird. Weiterhin sind mit ΔE_{c} und ΔEᵥ die jeweiligen Bandkantendiskontinuitäten für das Leitungsband und das Valenzband dargestellt, die sich am Übergang zwischen dem entspannten Silizium 3 und der verspannten Geₓsi₁₋ₓ Halbleiterlegierung jeweils ergeben.

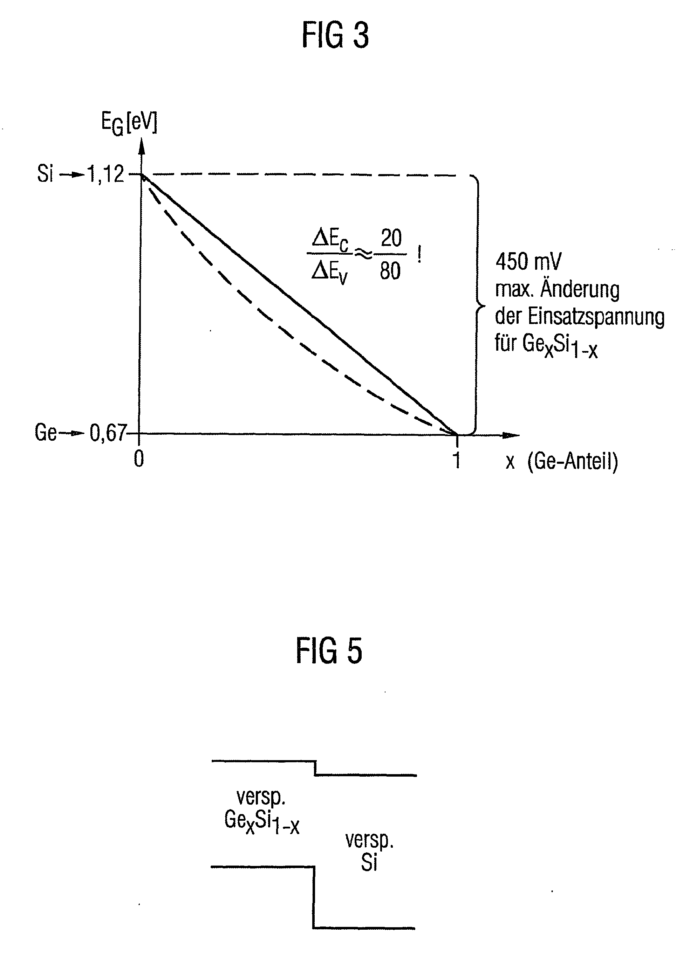

Figur 3 zeigt nunmehr eine grafische Darstellung zur Veranschaulichung des Verhaltens einer derartigen Bandlücke E_{G} in Abhängigkeit von einem jeweiligen Anteil x des zweiten Halbleitermaterials bzw. des Ge-Anteils. Gemäß Figur 3 ist bei einem Germanium-Anteil x von 0 die Bandlücke E_{G} identisch mit der von Silizium und liegt demzufolge bei 1,12 eV. Andererseits ist bei einem Germanium-Anteil x von 1 (100 %) ein reines Germanium-Halbleiterkristall vorhanden, weshalb die Bandlücke E_{G} von Germanium bei 0,67 eV erreicht wird. Über die Veränderung des Germanium-Anteils 0 < x < 1 innerhalb der Halbleiterlegierung der verspannten Halbleiterschicht 4 kann demzufolge eine Bandlücke E_{G} gemäß Figur 2A hochgenau eingestellt werden, wodurch sich die in Figur 2B dargestellte Einsatzspannung, welche Inversion in der verspannten Halbleiterschicht 4 bedeutet, festlegt. Bei Anlegen einer vorbestimmten Spannung V_{g} werden demzufolge die Bänder derart verbogen, dass das Valenzband der verspannten Schicht 4 an der Oberfläche zur Gate-Isolationsschicht 5 schließlich bis zum Ferminiveau f heranreicht und somit Inversion vorliegt. Der Kanal des Feldeffekttransistors wird zu diesem Zeitpunkt leitend, wodurch die Einsatzspannung festgelegt ist.

Gemäß Figur 3 kann demzufolge in einem Feldeffekttransistor gemäß dem ersten Ausführungsbeispiel durch gezielte Änderung des Germanium-Anteils x die Bandlücke derart verändert werden, dass sich schließlich eine gezielte Änderung der Einsatzspannung ergibt.

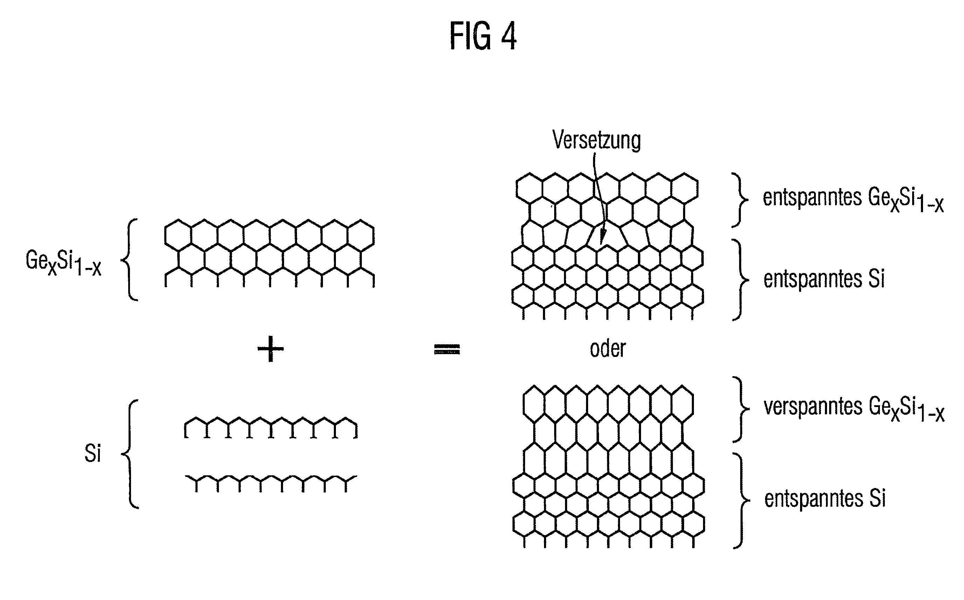

Figur 4 zeigt eine vereinfachte Darstellung zur Veranschaulichung der verschiedenen Möglichkeiten zum Kristallwachstum und insbesondere zur Realisierung einer entspannten Halbleiterschicht auf einem entspannten Ausgangsmaterial oder einer verspannten Halbleiterschicht auf einem entspannten Ausgangsmaterial. Demzufolge besitzt die Halbleiterlegierung GeₓSi₁₋ₓ eine größere Kristallstruktur bzw. Gitterkonstante als das Halbleitermaterial Si. Werden nunmehr diese Schichten zusammengefügt, so können die auf der rechten Seite dargestellten Kristallstrukturen entstehen, wobei entweder aufgrund von Versetzungen und Oberflächendefekten an der Grenzschicht eine entspannte GeₓSi₁₋ₓ-Schicht auf einer entspannten Si-Schicht ausgebildet wird oder im darunter dargestellten Fall keine derartigen Versetzungen an der Grenzschicht vorliegen und folglich die unterschiedlichen Gitterkonstanten der Kristalle unter Auftreten von mechanischen Verspannungen bzw. Stress aneinander angepasst werden. Im dargestellten Fall ergibt sich daraus eine verspannte GeₓSi₁₋ₓ-Halbleiterlegierung, die auf einer entspannten Si-Schicht ausgebildet ist. Weitergehende Informationen zu derartigen Halbleiter-Heterostrukturen sind insbesondere der Literaturstelle John C. Bean: "Silicon-Based Semiconductor Heterostructures: Col. IV Bandgap Engineering", Proceedings of IEEE, Vol. 80, Nr. 4, April 1992 zu entnehmen.

Da die Einsatzspannung vom Abstand des Ferminiveaus f von der Leitungs-/Valenzbandkante des Halbleiters abhängt, kann somit über den Ge-Anteil x die Einsatzspannung um etwa 200 mV für den n-/p-MOS-Feldeffekttransistor variabel eingestellt werden. Da sich jedoch bei verspanntem GeₓSi₁₋ₓ auf unverspanntem Si die Bandkantendiskontinuität zu 20 % auf das Leitungsband und zu 80 % auf das Valenzband verteilt, erhält man die in Figuren 2A und 2B unsymmetrische Einsatzspannung für einen n- und p-Feldeffekttransistor. Durch Auswahl eines geeigneten Metalls für die Gate-Schicht 6 mit einer Austrittsarbeit von 4,7 eV -200 mV kann nunmehr die Einsatzspannung von n- und p-Feldeffekttransistoren im reinen Silizium um -100 mV bzw. um +100 mV verschoben werden, also z.B. auf 400 mV bzw. 600 mV. Bei der in Figur 1 bzw. Fig. 2 vorgeschlagenen Halbleiterheterostruktur kann demzufolge mittels des Ge-Anteils x die Einsatzspannung für den n- bzw. p-Feldeffekttransistor auf 340 mV bzw. 360 mV hochgenau eingestellt werden.

Da die Auswahl derartiger geeigneter Gate-Schichten bzw. "mid gap"-Metalle für die Gate-Elektrode sehr schwierig ist und oftmals nur unzureichende Ergebnisse liefert, kann gemäß einem zweiten Ausführungsbeispiel eine zusätzliche entspannte Ge_{y}Si_{1-y} -Schicht und eine zusätzliche verspannte Si-Schicht verwendet werden, die sich zwischen dem entspannten Si und der verspannten GeₓSi₁₋ₓ Halbleiterlegierung befindet. Symmetrische Einsatzspannungen können dadurch auch unter Verwendung von nur einer einzigen gemeinsamen Gate-Elektrode bzw. Gate-schicht und einer entsprechenden Zusammensetzung der Ge-Anteile x und y in der Halbleiterheterostruktur eingestellt werden.

Die Figur 5 zeigt eine vereinfachte Darstellung zur Veranschaulichung eines Bandkantenverlaufs für eine verspannte GeₓSi₁₋ₓ-Schicht und einer verspannten Si-Schicht. Aufgrund der gegenläufigen Verteilung der Bandkantendiskontinuität zwischen Leitungs- und Valenzband können somit die vorstehend beschriebenen Unsymmetrien durch eine geeignete Zwischenschicht bzw. durch Einstellung eines Ge-Anteils der Zwischenschicht gezielt verändert werden.

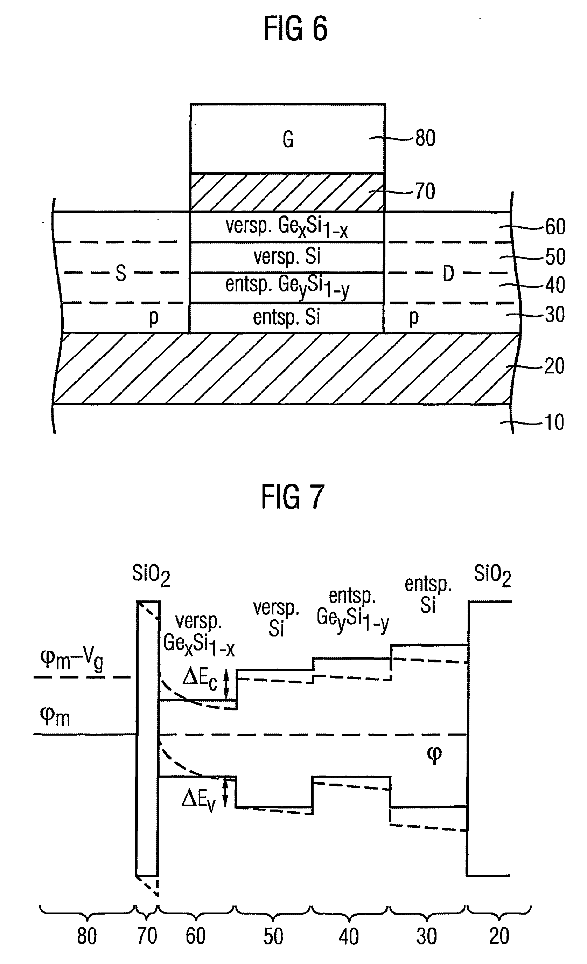

Figur 6 zeigt eine vereinfachte Schnittansicht eines Feldeffekttransistors gemäß einem zweiten Ausführungsbeispiel, wobei gleiche Bezugszeichen gleiche oder entsprechende Schichten bezeichnen, wie in Figuren 1 bis 3, und auf eine wiederholte Beschreibung nachfolgend verzichtet wird.

Wiederum wird auf einem Trägermaterial, das als oberste Schicht eine erste entspannte monokristalline Halbleiterschicht 30 aus einem ersten Halbleitermaterial, wie beispielsweise Silizium, aufweist, eine Heteroschichtstruktur ausgebildet. Das Trägermaterial kann hierbei wiederum entweder ein SOI-Substrat mit einem Silizium-Substrat 10 und einer Isolierschicht 20 oder ein Halbleitersubstrat mit einer vergrabenen Isolierschicht (buried oxide) aufweisen.

Im Gegensatz zum ersten Ausführungsbeispiel wird jedoch an der Oberfläche der ersten entspannten monokristallinen Halbleiterschicht 30 zunächst eine zweite entspannte monokristalline Halbleiterschicht 40 ausgebildet, die eine erste Halbleiterlegierung aus dem ersten Halbleitermaterial Si und zumindest einem zweiten Halbleitermaterial Ge aufweist. Genauer gesagt wird als erste Halbleiterlegierung Ge_{y}Si_{1-y} vorzugsweise mittels Molekularstrahlepitaxie ausgebildet, wobei wiederum ein Anteil y des Germaniums zur Kompensation der vorstehend beschriebenen Einsatzspannungs-Unsymmetrie frei einstellbar ist. Anschließend wird auf der zweiten entspannten Halbleiterschicht 40 eine erste verspannte monokristalline Halbleiterschicht 50 ausgebildet, die das erste Halbleitermaterial, d.h. Silizium aufweist. Wiederum können hierbei epitaktische Verfahren und insbesondere die Molekularstrahlepitaxie verwendet werden. An der Oberfläche der ersten verspannten Halbleiterschicht 50 wird schließlich eine zweite verspannte monokristalline Halbleiterschicht 60 ausgebildet, die eine zweite Halbleiterlegierung aus dem ersten und zweiten Halbleitermaterial aufweist, d.h. GeₓSi₁₋ₓ, wobei ein zweiter Anteil x des zweiten Halbleitermaterials bzw. der zweite Germanium-Anteil x wiederum frei einstellbar ist.

Durch die Kombination der verspannten und entspannten Halbleiterlegierungen mit ihren jeweils unterschiedlichen Germanium-Anteilen x und y kann demzufolge der in Figur 7 dargestellte symmetrische Bandkantenverlauf realisiert werden, wodurch sich für beliebige Gate-Materialien und beliebige Gate-Isolationsschichten 70 auf einfache und kostengünstige Weise symmetrische Einsatzspannungen für n-MOS- und p-MOS-Feldeffekttransistoren realisieren lassen. Insbesondere bei der Realisierung von CMOS-Schaltungen, bei denen jeweils ein n- und ein p-Feldeffekttransistor miteinander kombiniert sind, können derartige Feldeffekttransistoren zum Einsatz kommen. Gemäß Figur 7 ist hierbei mit durchgezogenen Linien der Bandkantenverlauf bei einer Flachbandspannung und mit strichlierten Linien der Bandkantenverlauf bei Inversion dargestellt.

Die Fertigstellung des Feldeffekttransistors erfolgt wiederum wie beim ersten Ausführungsbeispiel, wobei nach der Strukturierung der Gate-Isolationsschicht 70 und der Gate-Schicht 80 beispielsweise eine Ionenimplantation zum Ausbilden der Source-Gebiete S und Drain-Gebiete D erfolgt.

Hinsichtlich der Schichtdicken wird für die erste entspannte Halbleiterschicht 30 beispielsweise eine Dicke von 3 bis 10 nm und für die zweite entspannte Halbleiterschicht 40 eine Dicke von 3 bis 20 nm und vorzugsweise 5 nm eingestellt. Die erste verspannte Halbleiterschicht 50 weist beispielsweise eine Dicke von 3 bis 20 nm und vorzugsweise eine Dicke von 3 bis 5 nm auf, während die zweite verspannte Halbleiterschicht 60 eine Dicke von 3 bis 20 nm und vorzugsweise von 3 bis 5 nm aufweist. Die Gate-Isolationsschicht 70 besitzt wiederum eine Dicke von 1 bis 10 nm, während die Gate-Schicht 80 ca. 100 nm aufweisen kann.

Insbesondere sei darauf hingewiesen, dass in den beschriebenen Ausführungsbeispielen die Schichtdicken der jeweiligen Halbleiterschichten derart gewählt werden, dass ein stabiler Stress bzw. eine stabile Verspannung für vorzugsweise ausgewählte Germanium-Anteile von 0 bis 0,5 für x und y gewährleistet werden. Derartige Schichtdicken unterstützen dabei aus elektrostatischer Sicht (Kurzkanaleffekte) Kanallängen L bis zu etwa 20 bis 30 nm.

Auf diese Weise erhält man einen Feldeffekttransistor mit vollständig verarmtem Kanalgebiet, dessen Einsatzspannung frei wählbar und hochgenau eingestellt werden kann.

Insbesondere zukünftige Logik-Halbleiterbausteine, wie beispielsweise Mikro-Controller, Mikro-Prozessoren oder Telekommunikations-Chips mit geforderten Einsatzspannungen der Feldeffekttransistoren von etwa 350 mV oder kleiner können auf diese Weise hochgenau angepasst und kostengünstig hergestellt werden. Die Verwendung von ausgefallenen Gate-Materialien oder unterschiedlichen Herstellungsschritten für p- und n-MOS-Feldeffekttransistoren kann somit entfallen.

Die Erfindung wurde vorstehend an Hand eines vollständig verarmten p-Feldeffekttransistors für CMOS-Schaltungen beschrieben, der eine verspannte GeₓSi₁₋ₓ-Halbleiterlegierungsschicht aufweist.

## Patentansprüche

1. Feldeffekttransistor mit Heteroschichtstruktur mit einem Trägermaterial (1, 2, 3), das als oberste Schicht eine entspannte monokristalline Halbleiterschicht (3) aus einem ersten Halbleitermaterial (Si) aufweist;
einer verspannten monokristallinen Halbleiterschicht (4), die auf der entspannten Halbleiterschicht (3) ausgebildet ist und eine Halbleiterlegierung aus dem ersten Halbleitermaterial (Si) und zumindest einem zweiten Halbleitermaterial (Ge) aufweist, wobei ein Anteil x des zweiten Halbleitermaterials (Ge) frei einstellbar ist;
einer Gate-Isolationsschicht (5), die auf der verspannten Halbleiterschicht (4) ausgebildet ist;
einer Gate-Schicht (6), die auf der Gate-Isolationsschicht (5) ausgebildet ist; und
Drain-/Source-Gebieten (D/S), die zum Festlegen eines undotierten Kanalgebiets (K) seitlich von der Gate-Schicht (6) zumindest in der verspannten Halbleiterschicht (4) ausgebildet sind, wobei die entspannte Halbleiterschicht (3) eine Dicke von 3 bis 5 nm, und die verspannte Halbleiterschicht (4) eine Dicke von 3 bis 5 nm aufweist.

2. Feldeffekttransistor mit Heteroschichtstruktur mit
einem Trägermaterial (10, 20, 30), das als oberste Schicht eine erste entspannte monokristalline Halbleiterschicht (30) aus einem ersten Halbleitermaterial (Si) aufweist;
einer zweiten entspannten monokristallinen Halbeiterschicht (40), die auf der ersten entspannten Halbleiterschicht (30) ausgebildet ist und eine erste Halbleiterlegierung aus dem ersten Halbleitermaterial (Si) und zumindest einem zweiten Halbleitermaterial (Ge) aufweist, wobei ein erster Anteil y des zweiten Halbleitermaterials (Ge) frei einstellbar ist;
einer ersten verspannten monokristallinen Halbleiterschicht (50), die auf der zweiten entspannten Halbleiterschicht (40) ausgebildet ist und das erste Halbleitermaterial (Si) aufweist;
einer zweiten verspannten monokristallinen Halbleiterschicht (60), die auf der ersten verspannten Halbleiterschicht (50) ausgebildet ist und eine zweite Halbleiterlegierung aus dem ersten Halbleitermaterial (Si) und zumindest dem zweiten Halbleitermaterial (Ge) aufweist, wobei ein zweiter Anteil x des zweiten Halbleitermaterials (Ge) frei einstellbar ist; einer Gate-Isolationsschicht (70), die auf der zweiten verspannten Halbleiterschicht (60) ausgebildet ist;
einer Gate-Schicht (80), die auf der Gate-Isolationsschicht (70) ausgebildet ist; und
Drain-/Source-Gebieten (D/S), die zum Festlegen eines undotierten Kanalgebiets (K) seitlich von der Gate-Schicht zumindest in der zweiten verspannten Halbleiterschicht (60) ausgebildet sind.

3. Feldeffekttransistor nach Patentanspruch 2, **dadurch gekennzeichnet, dass**
die erste entspannte Halbleiterschicht (30) eine Dicke von 3 bis 10 nm,
die zweite entspannte Halbleiterschicht (40) eine Dicke von 3 bis 20 nm,
die erste verspannte Halbleiterschicht (50) eine Dicke von 3 bis 20 nm, und
die zweite verspannte Halbleiterschicht (60) eine Dicke von 3 bis 20 nm aufweist.

4. Feldeffekttransistor nach einem der Patentansprüche 1 bis 3, **dadurch gekennzeichnet, dass** die Summe der Dicken der entspannten und verspannten Halbleiterschichten (3, 4; 30, 40, 50, 60) kleiner ein Drittel einer Länge (L) des Kanalgebiets (K) aufweist.

5. Feldeffekttransistor nach einem der Patentansprüche 1 bis 4, **dadurch gekennzeichnet, dass** der Anteil des zweiten Halbleitermaterials in den Halbleiterlegierungen kleiner 0,5 beträgt und die Schichtdicke der verspannten Halbleiterschicht mit der Halbleiterlegierung derart gewählt wird, dass eine stabile Verspannung gewährleistet ist.

6. Feldeffekttransistor nach einem der Patentansprüche 1 bis 5, **dadurch gekennzeichnet, dass** die Gate-Isolationsschicht (5; 70) eine Dicke von 1 bis 10 nm aufweist.

7. Feldeffekttransistor nach einem der Patentansprüche 1 bis 6, **dadurch gekennzeichnet, dass** die Gate-Schicht (6; 80) ein metallisches Material mit einer Austrittsarbeit von 4,5 eV bis 4,9 eV und vorzugsweise 4,7 eV aufweist.

8. Feldeffekttransistor nach einem der Patentansprüche 1 bis 7, **dadurch gekennzeichnet, dass** das erste Halbleitermaterial Silizium und das zweite Halbleitermaterial Germanium darstellt.

9. Feldeffekttransistor nach einem der Patentansprüche 1 bis 8, **dadurch gekennzeichnet, dass** das Trägermaterial ein SOI-Substrat mit einer Isolationsschicht (2; 20) darstellt.

10. Feldeffekttransistor nach einem der Patentansprüche 1 bis 8, **dadurch gekennzeichnet, dass** das Trägermaterial ein Siliziumsubstrat mit vergrabener SiO₂-Schicht (2; 20) darstellt.

11. Feldeffekttransistor nach einem der Patentansprüche 1 bis 10, **dadurch gekennzeichnet, dass** die Gate-Isolationsschicht (5; 70) SiO₂ oder ein high-k-Dielektrikum aufweist.

12. Feldeffekttransistor nach einem der Patentansprüche 1 bis 11, **dadurch gekennzeichnet, dass** er ein Teil einer CMOS-Schaltung ist.

13. Verfahren zur Herstellung eines Feldeffekttransistors mit Heteroschichtstruktur mit den Schritten:
a) Vorbereiten eines Trägermaterials (1, 2, 3), das als oberste Schicht eine 3 bis 5 nm dicke entspannte monokristalline Halbleiterschicht (3) aus einem ersten Halbleitermateria1 (Si) aufweist;
b) Ausbilden einer 3 bis 5 nm dicken verspannten monokristallinen Halbleiterschicht (4) an der Oberfläche der entspannten Halbleiterschicht (3), wobei sie eine Halbleiterlegierung aus dem ersten Halbleitermaterial (Si) und zumindest einem zweiten Halbleitermaterial (Ge) darstellt und ein Anteil x des zweiten Halbleitermaterials (Ge) frei einstellbar ist;
c) Ausbilden einer Gate-Isolationsschicht (5) an der Oberfläche der verspannten Halbleiterschicht (4);
d) Ausbilden einer Gate-Schicht (6) an der Oberfläche der Gate-Isolationsschicht (5);
e) Strukturieren der Gate-Isolationsschicht (5) und der Gate-Schicht (6) zum Ausbilden eines strukturierten Gatestapels; und
f) Durchführen einer Ionenimplantation zum Ausbilden von Drain-/Source-Gebieten (D/S) unter Verwendung des strukturierten Gatestapels als Maske in zumindest der verspannten Halbleiterschicht (4), wobei die Drain-/Source-Gebiete ein undotiertes Kanalgebiet (K) festlegen.

14. Verfahren zur Herstellung eines Feldeffekttransistors mit Heteroschichtstruktur mit den Schritten:
a) Vorbereiten eines Trägermaterials (10, 20, 30), das als oberste Schicht eine erste entspannte monokristalline Halbleiterschicht aus einem ersten Halbleitermaterial (Si) aufweist;
b) Ausbilden einer zweiten entspannten monokristallinen Halbleiterschicht (40) an der Oberfläche der ersten entspannten Halbleiterschicht (30), die eine erste Halbleiterlegierung aus dem ersten Halbleitermaterial (Si) und zumindest einem zweiten Halbleitermaterial (Ge) aufweist, wobei ein erster Anteil y des zweiten Halbleitermaterials (Ge) frei einstellbar ist;
c) Ausbilden einer ersten verspannten monokristallinen Halbleiterschicht (50) an der Oberfläche der zweiten entspannten Halbleiterschicht (40), wobei das erste Halbleitermaterial (Si) verwendet wird;
d) Ausbilden einer zweiten verspannten monokristallinen Halbleiterschicht (60) an der Oberfläche der ersten verspannten Halbleiterschicht (50), wobei eine zweite Halbleiterlegierung aus dem ersten Halbleitermaterial (Si) und zumindest einem zweiten Halbleitermaterial (Ge) verwendet wird und ein zweiter Anteil x des zweiten Halbleitermaterials (Ge) wiederum frei einstellbar ist;
e) Ausbilden einer Gate-Isolationsschicht (70) an der Oberfläche der zweiten verspannten Halbleiterschicht (60);
f) Ausbilden einer Gate-Schicht (80) an der Oberfläche der Gate-Isolationsschicht (70);
g) Strukturieren der Gate-Schicht (80) und der Gate-Isolationsschicht (70) zum Ausbilden eines strukturierten Gatestapels; und
h) Durchführen einer Ionenimplantation unter Verwendung des strukturierten Gatestapels als Maske zum Ausbilden von Drain-/Source-Gebieten (D/S) in zumindest der zweiten verspannten Halbleiterschicht (60), wobei die Drain-/Source-Gebiete ein undotiertes Kanalgebiet (K) festlegen.

15. Verfahren nach Patentanspruch 13 oder 14, **dadurch gekennzeichnet, dass** das Ausbilden der entspannten und/oder verspannten Halbleiterschichten mittels Molekularstrahlepitaxie durchgeführt wird.

16. Verfahren nach einem der Patentansprüche 13 bis 15, **dadurch gekennzeichnet, dass** der Anteil des zweiten Halbleitermaterials in den Halbleiterlegierungen kleiner 0,5 beträgt und die Schichtdicke der verspannten Halbleiterschicht mit der Halbleiterlegierung derart gewählt wird, dass eine stabile Verspannung gewährleistet ist.

17. Verfahren nach einem der Patentansprüche 13 bis 16, **dadurch gekennzeichnet, dass** die Anteile des zweiten Halbleitermaterials (Ge) in den Halbleiterlegierungen in Abhängigkeit von einem verwendeten Gate-Material eingestellt wird.

18. Verfahren nach einem der Patentansprüche 13 bis 17, **dadurch gekennzeichnet, dass** die Anteile des zweiten Halbleitermaterials (Ge) in den Halbleiterlegierungen in Abhängigkeit von einer Symmetrieanforderung für n- oder p-Feldeffekttransistoren eingestellt werden.

## Claims

1. Field effect transistor with a heterostructure, comprising
a carrier material (1, 2, 3) which has a relaxed monocrystalline semiconductor layer (3) made of a first semiconductor material (Si) as the topmost layer;
a strained monocrystalline semiconductor layer (4), which is formed on the relaxed semiconductor layer (3) and has a semiconductor alloy comprising the first semiconductor material (Si) and at least one second semiconductor material (Ge), where a proportion x of the second semiconductor material (Ge) can be set freely;
a gate insulation layer (5) formed on the strained semiconductor layer (4);
a gate layer (6) formed on the gate insulation layer (5); and
drain/source regions (D/S), which, in order to define an undoped channel region (K), are formed laterally with respect to the gate layer (6) at least in the strained semiconductor layer (4), the relaxed semiconductor layer (3) having a thickness of 3 to 5 nm, and the strained semiconductor layer (4) having a thickness of 3 to 5 nm.

2. Field effect transistor with a heterostructure, comprising
a carrier material (10, 20, 30) which has a first relaxed monocrystalline semiconductor layer (30) made of a first semiconductor material (Si) as the topmost layer;
a second relaxed monocrystalline semiconductor layer (40), which is formed on the first relaxed semiconductor layer (30) and has a first semiconductor alloy comprising the first semiconductor material (Si) and at least one second semiconductor material (Ge), where a first proportion y of the second semiconductor material (Ge) can be set freely;
a first strained monocrystalline semiconductor layer (50), which is formed on the second relaxed semiconductor layer (40) and has the first semiconductor material (Si);
a second strained monocrystalline semiconductor layer (60), which is formed on the first strained semiconductor layer (50) and has a second semiconductor alloy comprising the first semiconductor material (Si) and at least the second semiconductor material (Ge), where a second proportion x of the second semiconductor material (Ge) can be set freely;
a gate insulation layer (70) formed on the second strained semiconductor layer (60);
a gate layer (80) formed on the gate insulation layer (70); and
drain/source regions (D/S), which, in order to define an undoped channel region (K), are formed laterally with respect to the gate layer at least in the second strained semiconductor layer (60).

3. Field effect transistor according to Patent Claim 2, **characterized in that**
the first relaxed semiconductor layer (30) has a thickness of 3 to 10 nm,
the second relaxed semiconductor layer (40) has a thickness of 3 to 20 nm,
the first strained semiconductor layer (50) has a thickness of 3 to 20 nm, and
the second strained semiconductor layer (60) has a thickness of 2 to 20 nm.

4. Field effect transistor according to one of Patent Claims 1 to 3, **characterized in that** the sum of the thicknesses of the relaxed and strained semiconductor layers (3, 4; 30, 40, 50, 60) is less than a third of the length (L) of the channel region (K).

5. Field effect transistor according to one of Patent Claims 1 to 4, **characterized in that** the proportion of the second semiconductor material in the semiconductor alloys is less than 0.5 and the layer thickness of the strained semiconductor layer with the semiconductor alloy is chosen in such a way that a stable strain is ensured.

6. Field effect transistor according to one of Patent Claims 1 to 5, **characterized in that** the gate insulation layer (5; 70) has a thickness of 1 to 10 nm.

7. The field effect transistor according to one of Patent Claims 1 to 6, **characterized in that** the gate layer (6; 80) has a metallic material with a work function of 4.5 eV to 4.9 eV and preferably 4.7 eV.

8. Field effect transistor according to one of Patent Claims 1 to 7, **characterized in that** the first semiconductor material constitutes silicon and the second semiconductor material constitutes germanium.

9. Field effect transistor according to one of Patent Claims 1 to 8, **characterized in that** the carrier material constitutes an SOI substrate with an insulation layer (2; 20).

10. Field effect transistor according to one of Patent Claims 1 to 8, **characterized in that** the carrier material constitutes a silicon substrate with a buried SiO₂ layer (2; 20).

11. Field effect transistor according to one of Patent Claims 1 to 10, **characterized in that** the gate insulation layer (5; 70) has SiO₂ or a high-k dielectric.

12. Field effect transistor according to one of Patent Claims 1 to 11, **characterized in that** it is part of a CMOS circuit.

13. Method for producing a field effect transistor with a heterostructure, comprising the steps of:
a) preparing a carrier material (1, 2, 3), which has a 3 to 5 nm thick relaxed monocrystalline semiconductor layer (3) made of a first semiconductor material (Si) as the topmost layer;
b) forming a 3 to 5 nm thick strained monocrystalline semiconductor layer (4) at the surface of the relaxed semiconductor layer (3), in which case it constitutes a semiconductor alloy comprising the first semiconductor material (Si) and at least one second semiconductor material (Ge) and a proportion x of the second semiconductor material (Ge) can be set freely;
c) forming a gate insulation layer (5) at the surface of the strained semiconductor layer (4);
d) forming a gate layer (6) at the surface of the gate insulation layer (5);
e) patterning the gate insulation layer (5) and the gate layer (6) in order to form a patterned gate stack; and
f) carrying out an ion implantation in order to form drain/source regions (D/S) using the patterned gate stack as a mask in at least the strained semiconductor layer (4), the drain/source regions defining an undoped channel region (K).

14. Method for producing a field effect transistor with a heterostructure, comprising the steps of:
a) preparing a carrier material (10, 20, 30), which has a first relaxed monocrystalline semiconductor layer made of a first semiconductor material (Si) as the topmost layer;
b) forming a second relaxed monocrystalline semiconductor layer (40) at the surface of the first relaxed semiconductor layer (30), which has a first semiconductor alloy comprising the first semiconductor material (Si) and at least one second semiconductor material (Ge), where a first proportion y of the second semiconductor material (Ge) can be set freely;
c) forming a first strained monocrystalline semiconductor layer (30) at the surface of the second relaxed semiconductor layer (40), the first semiconductor material (Si) being used;
d) forming a second strained monocrystalline semiconductor layer (60) at the surface of the first strained semiconductor layer (50), in which case a second semiconductor alloy comprising the first semiconductor material (Si) and at least one second semiconductor material (Ge) is used and a second proportion x of the second semiconductor material (Ge) can in turn be set freely;
e) forming a gate insulation layer (70) at the surface of the second strained semiconductor layer (60);
f) forming a gate layer (80) at the surface of the gate insulation layer (70);
g) patterning the gate layer (80) and the gate insulation layer (70) in order to form a patterned gate stack; and
h) carrying out an ion implantation using the patterned gate stack as a mask in order to form drain/source regions (D/S) in at least the second strained semiconductor layer (60), the drain/source regions defining an undoped channel region (K).

15. Method according to Patent Claim 13 or 14, **characterized in that** the formation of the relaxed and/or strained semiconductor layers is carried out by means of molecular beam epitaxy.

16. Method according to one of Patent Claims 13 to 15, **characterized in that** the proportion of the second semiconductor material in the semiconductor alloys is less than 0.5 and the layer thickness of the strained semiconductor layer having the semiconductor alloy is chosen in such a way that a stable strain is ensured.

17. Method according to one of Patent Claims 13 to 16, **characterized in that** the proportions of the second semiconductor material (Ge) in the semiconductor alloys are set in a manner dependent on a gate material used.

18. Method according to one of Patent Claims 13 to 17, **characterized in that** the proportions of the second semiconductor material (Ge) in the semiconductor alloys are set in a manner dependent on a symmetry requirement for n- or p-type field effect transistors.

## Revendications

1. Transistor à effet de champ ayant une structure à couches hétérogènes comprenant
un matériau (1, 2, 3) de support, qui a, comme couche la plus haute, une couche (3) semi-conductrice monocristalline relaxée en un premier matériau (Si) semi-conducteur ;
une couche (4) semi-conductrice monocristalline contrainte, qui est formée sur la couche (3) semi-conductrice relaxée et qui comporte un alliage semi-conducteur composé du premier matériau (Si) et d'au moins un deuxième matériau (Ge) semi-conducteur, une proportion x du deuxième matériau (Ge) semi-conducteur pouvant être réglée à volonté ;
une couche (5) isolante de grille, qui est formée sur la couche (4) semi-conductrice contrainte ;
une couche (6) de grille, qui est formée sur la couche (5) isolante de grille ; et
des zones (D/S) de drain/source, qui sont formées pour fixer une zone (K) de canal non dopée latéralement à la couche (6) de grille au moins dans la couche (6) semi-conductrice contrainte, la couche (5) semi-conductrice relaxée ayant une épaisseur de 3 à 5 nm, et la couche (4) semi-conductrice contrainte ayant une épaisseur de 3 à 5 nm.

2. Transistor à effet de champ ayant une structure à couches hétérogènes comprenant
un matériau (10, 20, 30) de support, qui a, comme couche la plus haute, une première couche (30) semi-conductrice monocristalline relaxée en un premier matériau (Si) semi-conducteur ;
une deuxième couche (40) semi-conductrice monocristalline relaxée, qui est formée sur la première couche (30) semi-conductrice relaxée et qui comporte un premier alliage semi-conducteur composé du premier matériau (Si) semi-conducteur et d'au moins un deuxième matériau (Ge) semi-conducteur, une première proportion y du deuxième matériau (Ge) semi-conducteur pouvant être réglée à volonté ;
une première couche (50) semi-conductrice monocristalline contrainte, qui est formée sur la deuxième couche (40) semi-conductrice relaxée et qui comporte le premier matériau (Si) semi-conducteur ;
une deuxième couche (60) semi-conductrice monocristalline contrainte, qui est formée sur la première couche (50) semi-conductrice contrainte et qui comporte un deuxième alliage semi-conducteur composé du premier matériau (Si) semi-conducteur et d'au moins le deuxième matériau (Ge) semi-conducteur, une deuxième proportion x du deuxième matériau (Ge) semi-conducteur pouvant être réglée à volonté ;
une couche (70) isolante de grille, qui est formée sur la deuxième couche (60) semi-conductrice contrainte ;
une couche (80) de grille, qui est formée sur la couche (70) isolante de grille ; et
des zones (D/S) de drain/source, qui sont formées pour fixer une zone (K) de canal non dopée latéralement à la couche de grille au moins dans la deuxième couche (60) semi-conductrice contrainte.

3. Transistor à effet de champ suivant la revendication 2, **caractérisé en ce que**
la première couche (30) semi-conductrice relaxée a une épaisseur de 3 à 10 nm,
la deuxième couche (40) semi-conductrice relaxée a une épaisseur de 3 à 20 nm,
la première couche (50) semi-conductrice contrainte a une épaisseur de 3 à 20 nm, et
la deuxième couche (60) semi-conductrice contrainte a une épaisseur de 3 à 20 nm.

4. Transistor à effet de champ suivant l'une des revendications 1 à 3, **caractérisé en ce que** la somme des épaisseurs des couches (3, 4 ; 30, 40, 50, 60) semi-conductrices relaxées et contraintes est plus petite qu'un tiers d'une longueur (L) de la zone (K) de canal.

5. Transistor à effet de champ suivant l'une des revendications 1 à 4, **caractérisé en ce que** la proportion du deuxième matériau semi-conducteur dans les alliages semiconducteurs est plus petite que 0,5 et l'épaisseur de la couche semi-conductrice contrainte ayant l'alliage semi-conducteur est choisie de manière à assurer une contrainte stable.

6. Transistor à effet de champ suivant l'une des revendications 1 à 5, **caractérisé en ce que** la couche (5 ; 70) isolante de grille a une épaisseur de 1 à 10 nm.

7. Transistor à effet de champ suivant l'une des revendications 1 à 6, **caractérisé en ce que** la couche (6 ; 80) de grille comporte un matériau métallique ayant un travail de sortie de 4,5 eV à 4,9 eV et, de préférence, de 4,7 eV .

8. Transistor à effet de champ suivant l'une des revendications 1 à 7, **caractérisé en ce que** le premier matériau semi-conducteur représente du silicium et le deuxième matériau semi-conducteur du germanium.

9. Transistor à effet de champ suivant l'une des revendications 1 à 8, **caractérisé en ce** le matériau de support représente un substrat SOI ayant une couche (2 ; 20) isolante.

10. Transistor à effet de champ suivant l'une des revendications 1 à 8, **caractérisé en ce que** le matériau de support représente un substrat de silicium ayant une couche (2 ; 20) enterrée de SᵢO₂.

11. Transistor à effet de champ suivant l'une des revendications 1 à 10, **caractérisé en ce que** la couche (5 ; 70) isolante de grille comporte du SᵢO₂ ou un diélectrique à grand k.

12. Transistor à effet de champ suivant l'une des revendications 1 à 11, **caractérisé en ce qu'**il fait partie d'un circuit CMOS.

13. Procédé de production d'un transistor à effet de champ ayant une structure à couches hétérogènes, comprenant les stades dans lesquels :
a) on prépare un matériau (1, 2, 3) de support, qui a, comme couche la plus haute, une couche (3) semi-conductrice monocristalline relaxée d'une épaisseur de 3 à 5 nm et qui peut être en un premier matériau (Si) semi-conducteur ;
b) on forme une couche (4) semi-conductrice monocristalline contrainte d'une épaisseur de 3 à 5 nm à la surface de la couche (3) semi-conductrice relaxée, cette couche (4) représentant un alliage semi-conducteur composé du premier matériau (Si) semi-conducteur et d'au moins un deuxième matériau (Ge) semi-conducteur et une proportion x du deuxième matériau (Ge) semi-conducteur pouvant être réglée à volonté ;
c) on forme une couche (5) isolante de grille à la surface de la couche (4) semi-conductrice contrainte ;
d) on forme une couche (6) de grille à la surface de la couche (5) isolante de grille ;
e) on structure la couche (5) isolante de grille et la couche (6) de grille pour former une pile de grille structurée ; et
f) on effectue une implantation d'ion pour former des zones (D/S) de drain/source en utilisant la pile de grille structurée comme masque dans au moins la couche (4) semi-conductrice contrainte, les zones de drain/source fixant une zone (K) de canal non dopée.

14. Procédé de production d'un transistor à effet de champ ayant une structure à couches hétérogènes, comprenant les stades dans lesquels :
a) on prépare un matériau (10, 20, 30) de support, qui comporte, comme couche la plus haute, une première couche semi-conductrice monocristalline relaxée en un premier matériau (Si) semi-conducteur ;
b) on forme une deuxième couche (40) semi-conductrice monocristalline relaxée à la surface de la première couche (30) semi-conductrice relaxée, cette couche (40) comportant un premier alliage semi-conducteur composé du premier matériau (Si) semi-conducteur et d'au moins un deuxième matériau (Ge) semi-conducteur, une première proportion y du deuxième (Ge) semi-conducteur pouvant être réglée à volonté ;
c) on forme une première couche (50) semi-conductrice monocristalline contrainte à la surface de la deuxième couche (40) semi-conductrice relaxée en utilisant le premier matériau (Si) semi-conducteur ;
d) on forme une deuxième couche (60) semi-conductrice monocristalline contrainte à la surface de la première couche (50) semi-conductrice contrainte en utilisant un deuxième alliage semi-conducteur composé du premier matériau (Si) semi-conducteur et d'au moins un deuxième matériau (Ge) semi-conducteur et une deuxième proportion x du deuxième matériau (ge) semi-conducteur pouvant à nouveau être réglée à volonté ;
e) on forme une couche (70) isolante de grille à la surface de la deuxième couche (60) semi-conductrice contrainte ;
f) on forme une couche (80) de grille à la surface de la couche (70) isolante de grille ;
g) on structure la couche (80) de grille et la couche (70) isolante de grille pour former une pile de grille structurée ; et
h) on effectue une implantation d'ion en utilisant la pile de grille structurée comme masque pour former des zones (D/S) de drain/source dans au moins la deuxième couche (60) semi-conductrice contrainte, les zones de drains/sources fixant une zone (K) de canal non dopée.

15. Procédé suivant l'une des revendications 13 ou 14, **caractérisé en ce que** l'on effectue la formation des couches semi-conductrices relaxées et/ou contraintes au moyen d'une épitaxie à jet moléculaire.

16. Procédé suivant l'une des revendications 13 ou 15, **caractérisé en ce que** la proportion du deuxième matériau semi-conducteur dans les alliages semi-conducteur est plus petite que 0,5 et l'épaisseur de la couche semi-conductrice contrainte ayant l'alliage semi-conducteur est choisie de manière à assurer une contrainte stable.

17. Procédé suivant l'une des revendications 13 ou 16, **caractérisé en ce que** l'on règle les proportions du deuxième matériau (Ge) semi-conducteur dans les alliages semiconducteurs en fonction d'un matériau de grille utilisé.

18. Procédé suivant l'une des revendications 13 ou 17, **caractérisé en ce qu'**on règle les proportions du deuxième matériau (Ge) semi-conducteur dans les alliages semiconducteurs en fonction d'une exigence de symétrie pour des transistor à effet de champ n ou p.
